# EUROPÄISCHE PATENTSCHRIFT

(11) **EP 1 258 084 B1**
(45) Veröffentlichungstag und Bekanntmachung des Hinweises auf die Patenterteilung: **25.05.2005**
(21) Anmeldenummer: 01901151.9
(22) Anmeldetag: 16.01.2001
(51) Int. Cl.: H03K 17/94

(54) **VORRICHTUNG UND VERFAHREN ZUM AUSWERTEN EINES VON EINEM NÄHERUNGSSENSOR STAMMENDEN NUTZSIGNALS**
DEVICE AND METHOD FOR EVALUATING A USEFUL SIGNAL ORIGINATING FROM A PROXIMITY SENSOR
PROCEDE ET DISPOSITIF POUR EVALUER UN SIGNAL UTILE PROVENANT D'UN DETECTEUR DE PROXIMITE

(30) Priorität: 18.01.2000 DE 10001943
(43) Veröffentlichungstag der Anmeldung: 20.11.2002
(73) Patentinhaber: Reime, Gerd, 75328 Schömberg (DE)
(72) Erfinder: Reime, Gerd, 75328 Schömberg (DE)
(74) Vertreter: Reinhardt, Harry
(86) Internationale Anmeldenummer: PCT/EP2001/000441
(87) Internationale Veröffentlichungsnummer: WO 2001/054277

(56) Entgegenhaltungen:
- EP-A- 0 518 648
- DE-A- 19 914 114
- US-A- 4 381 446
- US-A- 4 943 712
- US-A- 5 592 033
- PATENT ABSTRACTS OF JAPAN vol. 013, no. 330 (E-793), 25. Juli 1989 (1989-07-25) -& JP 01 093915 A (MITSUBISHI ELECTRIC CORP), 12. April 1989 (1989-04-12)
- PATENT ABSTRACTS OF JAPAN vol. 007, no. 266 (P-239), 26. November 1983 (1983-11-26) -& JP 58 147670 A (TOKYO SHIBAURA DENKI KK), 2. September 1983 (1983-09-02)
- FUKUYAMA T: "WAYS TO PREVENT MALFUNCTION IN PHOTOELECTRIC SWITCHES" JEE JOURNAL OF ELECTRONIC ENGINEERING,JP,DEMPA PUBLICATIONS INC. TOKYO, Bd. 21, Nr. 205, 1984, Seiten 59-63, XP002038101 ISSN: 0385-4507

## Beschreibung

Die Erfindung betrifft eine Vorrichtung sowie ein Verfahren zum Auswerten eines von einem Näherungssensor, insbesondere von einem opto-elektronischen Näherungssensor stammenden Nutzsignals nach dem Oberbegriff der Ansprüche 1 oder 11.

In fast allen elektrischen oder elektronischen Geräten werden Schalter zur manuellen Bedienung verwendet. Diese Schalter sind fast immer mechanisch aufgebaut, wobei zwei Metallteile in Kontakt bzw. außer Kontakt gebracht werden, um einen Stromkreis zu schließen bzw. zu öffnen. Dieser mechanische Aufbau hat jedoch unter anderem den Nachteil, dass er mechanische Verschleißteile und somit nur eine begrenzte Lebensdauer aufweist und grundsätzlich wasserempfindlich ist, so dass im Bedarfsfall eine aufwendige Kapselung notwendig ist.

Es sind schon optische Schalter bekannt geworden, die jedoch bisher recht aufwendig und somit teuer sind und noch nicht den geforderten Standard bezüglich der Funktionssicherheit aufweisen. Optische Schalter haben jedoch grundsätzlich Vorteile, da sie im allgemeinen ohne bewegliche mechanische Teile auskommen und der Schaltvorgang durch bloßes Antippen oder Berühren einer Schaltfläche oder durch bloße Näherung an einen Sensor ausgelöst werden kann.

Aus PATENT ABSTRACTS OF JAPAN vol. 007, no. 266 (P-239), 26. November 1983 und aus JP 58 147670 ist eine optoelektronische Detektionsschaltung bekannt, bei der zur Elimination der Detektionsempfindlichkeit ein einziges Signal zerlegt und ein Teil des Signals zeitverzögert einem Vergleicher zugeführt wird. Es erfolgt eine Differenzierung des DC-Signals. Dabei geht es nicht um die Erfassung und vor allem nicht um die Auswertung eines für eine Schaltbewegung typischen Signalverlaufs.

Andere Patentanmeldungen beschäftigen sich mit Hystereseproblemen, um Signale eindeutig vor allem vor Hintergrundsignalen zu erkennen. So wird in der EP 0 518 648 als auch in PATENT ABSTRACTS OF JAPAN vol.13, no. 330 (E793), 25. Juli 1989 und JP 01 093915 eine Schaltung zur Beseitigung von Hystereseproblemen beschrieben. Damit werden jedoch nicht die bei der Bewegung eines Objekts entstehenden Signalverläufe auf eine für eine Schaltbewegung signifikante Abläufe geprüft.

Auch die US 5,592,033 beschäftigt sich zum Zuschalten einer zweiten Spannungsquelle mit Hystereseproblemen. Dabei wird mit einer verhältnismäßig langen Zeitverzögerung gearbeitet, um kurzfristig Änderungen im Umgebungslicht zu unterdrücken (Spalte 6, Zeilen 60-65). Beobachtet werden die beiden Zustandsänderungen eines einzigen Signals.

Bei der US 4,381,466 A und der zugehörigen Veröffentlichung FUKUYAMA, T.: "Ways to prevent malfunction in photoelectric switches", JEE JOURNAL OF ELECTRIC ENGINEERING, JP, DEMPA PUBLICATIONS INC., Tokyo, Bd.21, Nr. 205, 1984, Seiten 59-63, werden die von einer optelektronischen Detektionsschaltung ermittelten Signale über ein Schieberegister von Interferenzen bereinigt. Damit beraubt sich diese Schaltung jedoch der Möglichkeiten einer Erfassung von dynamischen Änderungen, wie sie bei Schaltvorgängen auftreten. Ohnehin geht es hierbei nicht um die Erkennung von für die Annäherung und Wegnahme eines Objekts typische Signalverläufe.

Weiterhin sind in der Technik sogenannte Näherungs- oder auch Regensensoren bekannt, mittels denen die Bewegung eines Objekts auf eine Fläche hin oder die Berührung oder Benetzung einer Fläche detektiert werden kann, wobei hier Vorrichtungen bekannt sind, die ein Signal abgeben, welches Informationen bezüglich der Bewegungsrichtung und der Bewegungsgeschwindigkeit des Objektes enthält. Eine solche Vorrichtung ist beispielsweise aus der WO 95/01561 bekannt.

Aufgabe der Erfindung ist es, eine Vorrichtung bzw. ein Verfahren zum Auswerten eines von einem Näherungssensor stammenden Nutzsignals zur Verfügung zu stellen, mittels der sich ein optischer Schalter betreiben lässt. Optischer Schalter heißt hier, dass mittels einer definierten Bewegung, beispielsweise eines Fingers, ein definierter Schaltvorgang ausgelöst wird, nämlich insbesondere das Unterbrechen bzw. Schließen eines Stromkreises.

Diese Aufgabe wird mit einer Vorrichtung mit den Merkmalen des Anspruchs 1 oder durch ein Verfahren mit den Merkmalen des Anspruches 11 gelöst. Vorteilhafte Ausführungsformen ergeben sich aus den abhängigen Ansprüchen.

Zur besseren Darstellung der Erfindung wird zunächst kurz die in der WO 95/01561 beschriebene Anordnung dargestellt. Es muss jedoch betont werden, dass die vorliegende Erfindung nicht nur mit der dort beschriebenen Anordnung betrieben werden kann, sondern immer dann, wenn ein Nutzsignal vorliegt, welches Geschwindigkeits- und Richtungsinformationen über ein sich bewegendes Objekt enthält. Diese Geschwindigkeitsinformationen sind in der Regel nur eindimensional erhältlich, was für die Funktion der erfindungsgemäßen Vorrichtung auch ausreichend ist, mehrdimensionale Informationen können aber ebenso ausgewertet werden. Im vorliegenden Fall ist das Nutzsignal ein analoges Spannungssignal, dies ist jedoch nicht zwingend erforderlich. Es könnte sich beispielsweise auch um ein digitalisiertes Signal handeln.

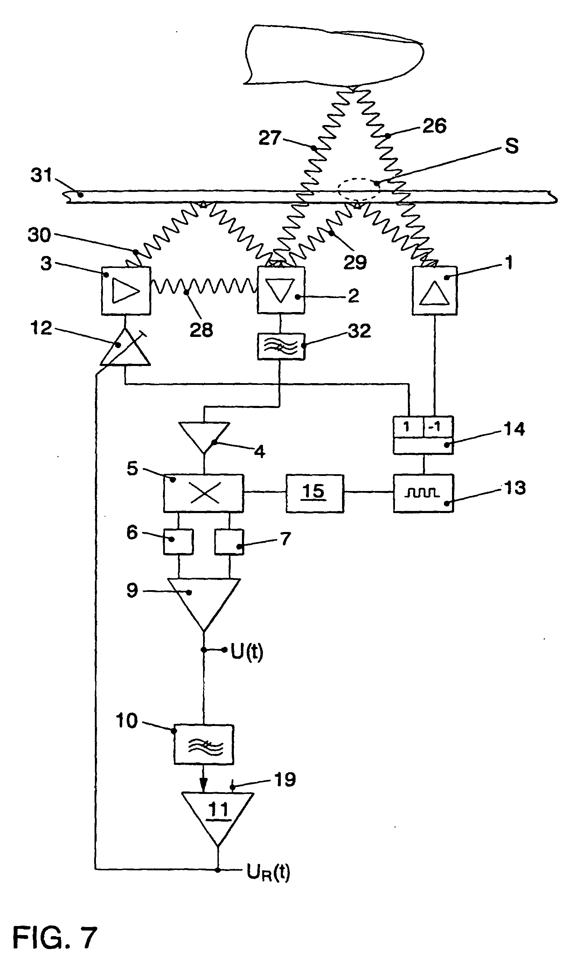

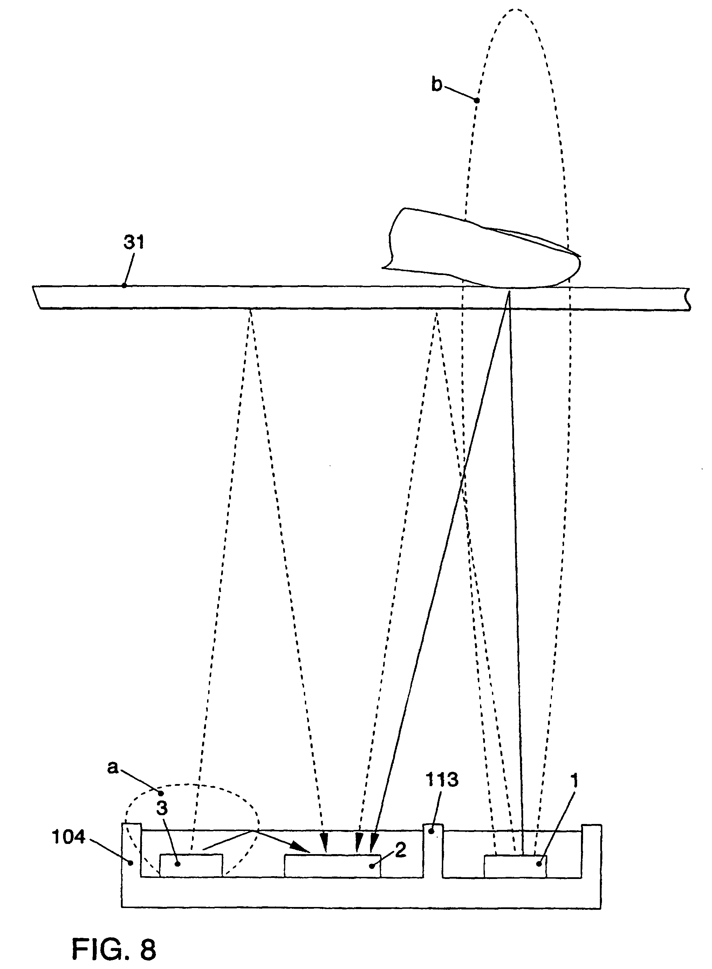

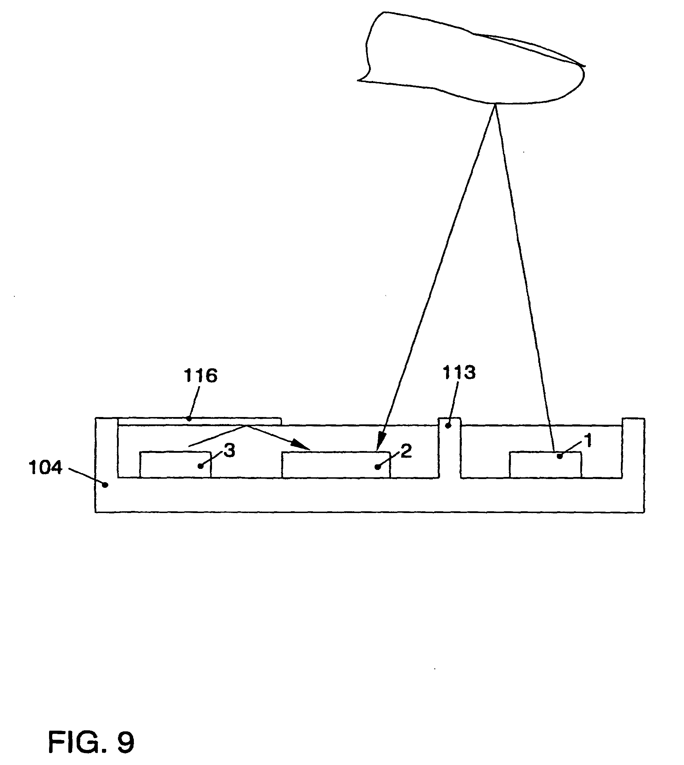

In Figur 7 ist ein Näherungssensor dargestellt, wie er im wesentlichen aus der WO 95/01561 bekannt ist. Unter einer Glasplatte 31 sind wenigstens zwei Leuchtdioden 1,3 angeordnet, deren Licht zumindest teilweise an der Glasplatte 31 reflektiert wird und auf die Fotodiode 2 auftreffen. Als Fotodiode kann auch eine entsprechend beschaltete Leuchtdiode dienen. Die Glasplatte oder eine andere Oberfläche sollte für Licht zumindest in einem bestimmten Wellenlängenbereich durchlässig sein. Das von der Leuchtdiode 2 emittierte Licht wird hier nicht als Messstrecke dienen, sondern wird lediglich zur Fremdlichtkompensation benötigt. Es ist deshalb denkbar und in manchen Fällen auch zweckmäßig, den Lichtweg dieser Diode dahingehend zu blockieren, dass er nicht in den Außenraum treten kann. Eine Anordnung 116 zum Blockieren einer der beiden Lichtstrahlen ist in Fig. 9 dargestellt. Weiterhin ist denkbar, die erste Leuchtdiode 1 als weitabstrahlende Laserdiode mit Strahlungsbereich b und die zweite Leuchtdiode als nur im Nahfeld abstrahlende Leuchtdiode mit Strahlungsbereich a auszubilden (Fig. 8). Zusätzlich können die Leuchtdioden durch eine Trennwand 113 im Gehäuse 104 voneinander getrennt sein. Es handelt sich hierbei um eine Modifikation der in der WO 95/01561 beschriebenen Anordnung, die für den vorliegenden Einsatzzweck sinnvoll sein kann.

Das Licht der Diode 1 wird an der Glasplatte 31 nur teilweise reflektiert und tritt somit in den Außenraum aus, wobei es wiederum von einem Objekt, hier einem Finger, reflektiert wird und somit teilweise in die Fotodiode 2 zurückgestreut werden kann. Die beiden Leuchtdioden werden mittels eines Taktgenerators 13 mit Spannung versorgt, wobei das Spannungssignal einer der beiden Dioden invertiert wird. Bei gleichmäßiger Leuchtleistung der Dioden und bei genauer symmetrischer Reflektion, beziehungsweise bei geeigneter Regelung der Leuchtstärke einer der beiden Dioden (s. unten) steht am Ausgang der Fotodiode 2 ein Gleichspannungssignal an, welches um Gleichspannungs- und niederfrequente Wechselanteile zu beseitigen einem Hochpass 132 zugeführt wird. Der Hochpass 132, dessen Grenzfrequenz unterhalb der Frequenz des Taktgenerators 13 liegt, setzt das ihm zugeführte Signal auf "0", solange es sich hierbei um ein Gleichspannungssignal handelt. Mit dieser Anordnung werden Einflüsse von Fremdlichtquellen ausgeschlossen.

Dieses so gefilterte Signal wird einem Verstärker 4 und dann einem Synchrondemodulator 5 zugeführt. Der Synchrondemodulator 5 erhält sein Taktsignal vom Frequenzgenerator 13, wobei dieses Taktsignal durch die Laufzeitregelung 15 zur Anpassung an die Signallaufzeiten im Hochpass 132 und im Verstärker 4 entsprechend verzögert ist. Der Synchrondemodulator 5 teilt das im Signalweg des Lichtempfängers 2, des Hochpassfilters 132 und des Vorverstärkers 4 gemeinsame Signal der Lichtquellen 1 und 3 wieder auf zwei getrennte Wege auf. Die vom Synchrondemodulator 5 herausgeschnittene Signalabschnitte werden in den Tiefpassfiltern 6 und 7 von störenden Spektralbereichen bereinigt und dem Vergleicher 9 zugeführt. Im dargestellten Fall besteht der Vergleicher 9 aus einem einfachen Operationsverstärker. An den Ausgängen der jeweiligen Tiefpassfilter 6 und 7 stehen die den Lichtsendem entsprechenden Differenzwerte an. Im entsprechend abgestimmten Zustand also zwei mal der Wert Null. Diese beiden Signale werden dem Vergleicher 9 zugeführt. Am Ausgang dieses Vergleichers liegt der Spannungswert U (t), das Nutzsignal an. Dieses Signal wird noch über einen Tiefpass 10 der Signalzentrierstufe 11 zugeführt.

Der Ausgang der Signalzentrierstufe 11 ist mit einem Regler 12 verbunden, der die Signalspannung für die Leuchtdiode 3 regelt. Durch diese Anordnung wird erreicht, dass sich das Nutzsignal zwar bei einer Änderung der Reflektion des von der Leuchtdiode 1 ausgesandten Lichtstrahls ändert, jedoch stets wieder auf den Nullwert zurückgeführt wird. Die Zeitkonstante für dieses Zurückführen wird im Ausführungsbeispiel durch den Tiefpassfilter 10 bestimmt.

Aufgabe der Erfindung ist es nun, das Nutzsignal U(t) dahingehend zu nutzen, dass durch eine definierte Bewegung eines Objekts ein definierter Schaltvorgang ausgelöst wird. Im vorliegenden Beispiel soll das Tippen eines Fingers, einer Hand oder eines anderen Körperteils des Benutzers auf einen sensoraktiven Bereich S der Glasplatte 31 detektiert und somit ein Schaltvorgang ausgelöst werden. Es sind jedoch auch Anwendungen denkbar, bei denen die Bewegung eines mechanischen Elements, beispielsweise eines sogenannten "Knackfrosches" detektiert werden soll.

Die Erfindung wird nun anhand eines Ausführungsbeispiels näher erläutert. Es zeigen:

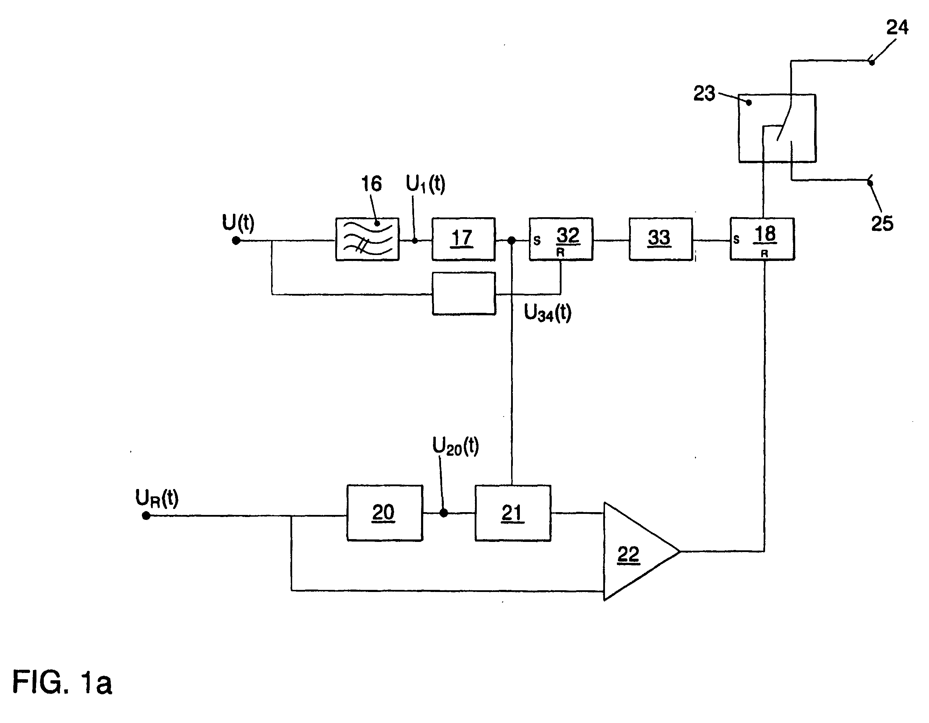

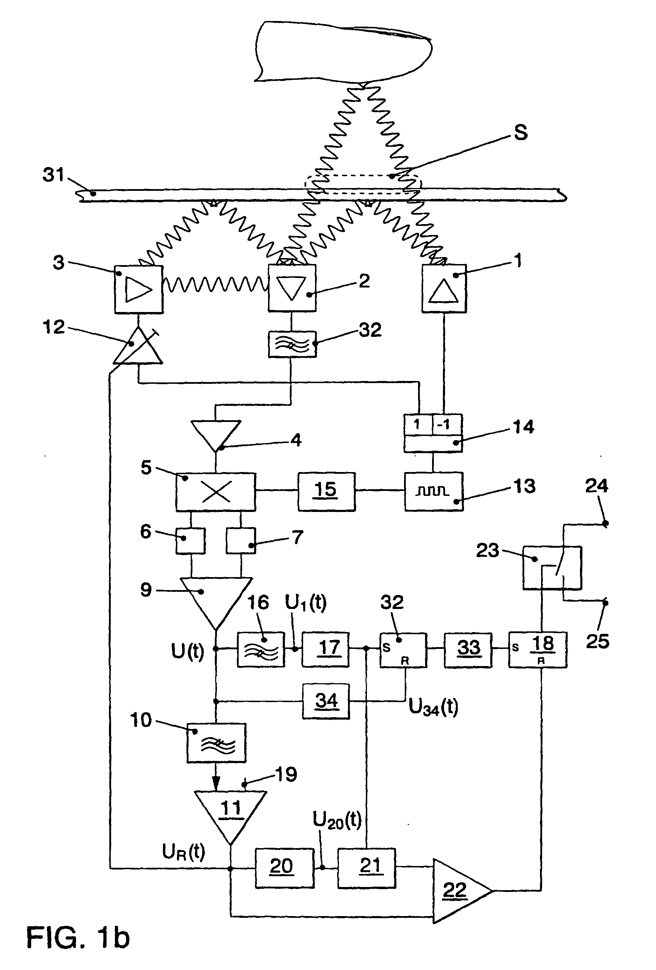

- Fig. 1a: eine Schaltungsanordnung zum erfindungsgemäßen Auswerten des Nutzsignals,
- Fig. 1 b: eine komplette Anordnung eines optischen Schalters
- Fig. 2: den Verlauf des Nutzsignals U(t) beim Antippen des sensoraktiven Bereichs,
- Fig. 3.1: den Verlauf des Messsignals beim Überstreichen des sensoraktiven Bereichs,

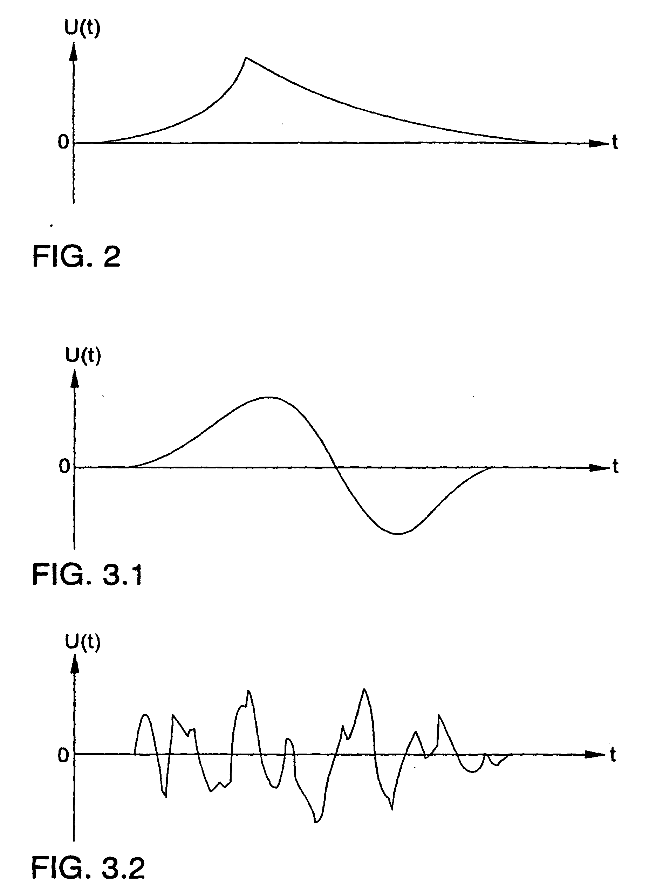

- Fig. 3.1: den Verlauf des Nutzsignals, wenn beispielsweise ein Tuch auf der Glasplatte rasch hin und her bewegt wird.

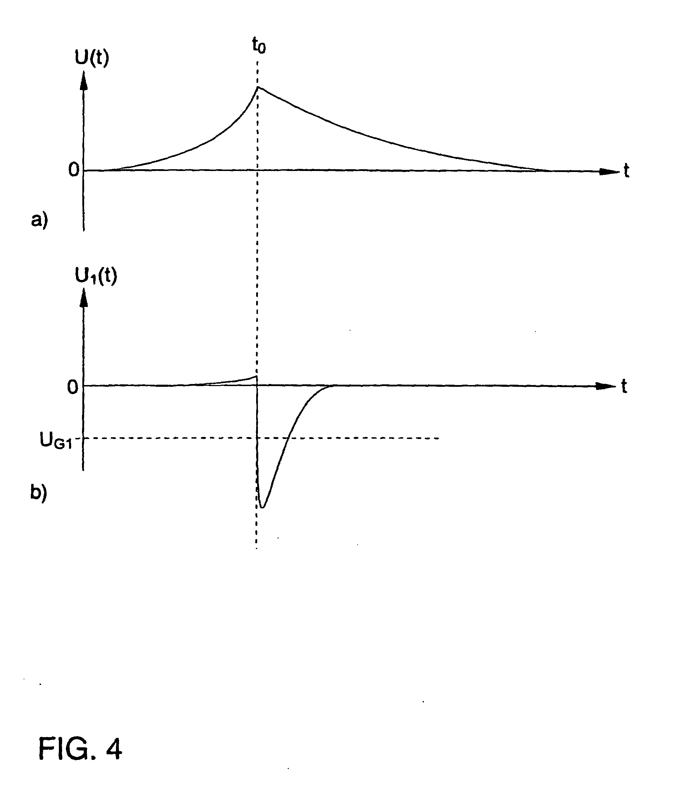

- Fig. 4a: den Verlauf des Nutzsignals U(t) beim Antippen des sensoraktiven Bereichs,
- Fig. 4b: den Verlauf des differenzierten Bewegungssignals U₁(t) beim Antippen des sensoraktiven Bereichs,

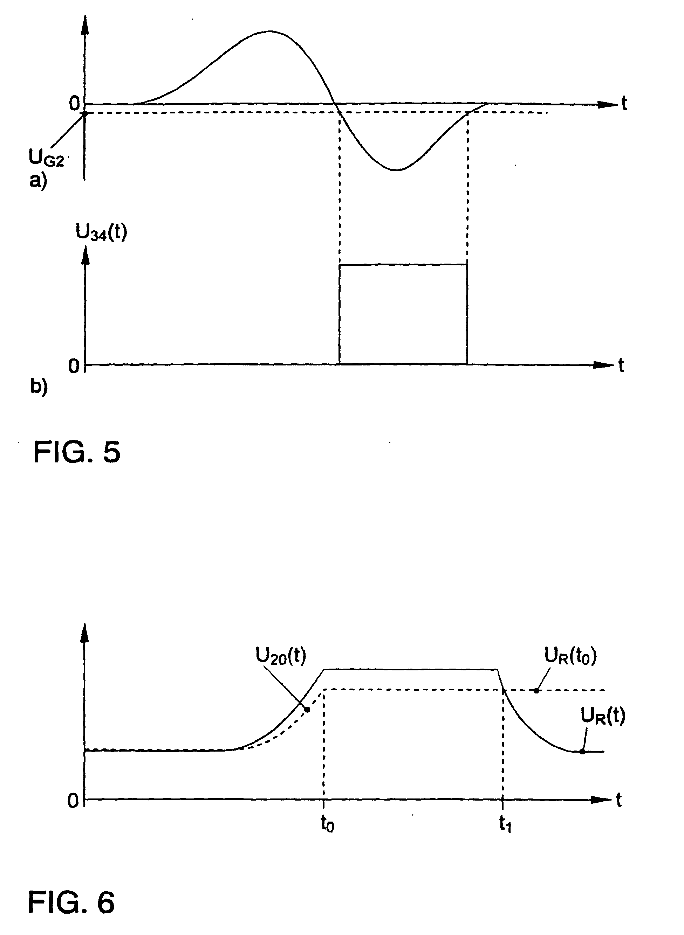

- Fig. 5a: den Verlauf des Messsignals beim Überstreichen des sensoraktiven Bereichs,
- Fig. 5b: den Verlauf des Ausgangssignals des ersten Schwellwertschalters in der in Fig. 5a dargestellten Situation,
- Fig. 6: Die Signalverläufe von U₂₀(t) und U_{R}(t), sowie den gespeicherten Wert U_{R}(t₀)
- Fig. 7: einen Näherungssensor nach dem Stand der Technik,
- Fig. 8, 9: mögliche Modifikationen des Näherungssensors aus Fig. 7.

In den Fign. 2, 3.1 und 3.2 ist das von der oben beschriebenen Sensoreinrichtung abgegebene Nutzsignal U(t) bei verschiedenen Situationen dargestellt. In Fig. 2 ist das Nutzsignal U(t) beim Antippen des sensoraktiven Bereichs S aufgetragen. Durch ein solches Signal soll ein Schaltvorgang ausgelöst werden. In den Fign. 3.1 bzw. 3.2 sind Nutzsignalverläufe aufgetragen, wie sie beim einmaligen Überstreichen bzw. beim Hin- und Herwischen über den sensoraktiven Bereich S auftreten. Solche Signalverläufe sollen keinen Schaltvorgang auslösen. Dieses Ziel wird bei diesem Ausführungsbeispiel wie folgt erreicht (Fig. 1a):

Das Nutzsignal U(t) wird dem Hochpassfilter 16 zugeführt, der hier als Differenzierglied wirkt, so dass an dessen Ausgang der Wert U₁(t) des differenzierte Bewegungssignals ansteht. Bei einer Bewegung eines Objekts, beispielsweise eines Fingers, auf die sensoraktive Oberfläche der Glasplatte 31 hin, steigt der Wert U(t) des Nutzsignals analog zur Bewegung langsam an und bleibt abrupt stehen, wenn der Finger auf der Glasplatte 31 abgebremst wird, siehe Figur 2 und Fig. 4a. Bleibt der Finger unbewegt liegen, wird der Wert U(t) des Nutzsignals langsam wieder auf U₀ zurück geregelt. Die abrupte Wertänderung des Nutzsignals führt am Ausgang des Hochpassfilters 16 zu einem Sprung des Bewegungssignalwerts U₁(t), siehe Fig. 4b. Dieses wird vom Schwellwertschalter 17 bei Überschreitung eines vorgegebenen negativen Wertes U_{G1} erkannt und der mit dem Set-Eingang des ersten FlipFlop 32 verbundene Ausgang des ersten Schwellwertschalters 17 wird auf aktiv gesetzt und somit das erste FlipFlop 32 gesetzt. Die Grenzfrequenz des Hochpassfilters 16 wird so gewählt, dass ein Antippen mit mäßiger Geschwindigkeit noch zu einem gut zu detektierenden Signal führt. Die Grenzfrequenz könnte beispielsweise im Bereich von 100 Hertz liegen.

In diesem Fall wird also ein aus dem Nutzsignal erzeugtes Signal, nämlich das durch Differentiation gewonnene Bewegungssignal verwendet, das einen ersten Vorgang auslöst, wenn dessen Wert U₁(t) einen bestimmten Grenzwert U_{G1} überschreitet. Es sind jedoch auch Schaltungsanordnungen und Anwendungsfälle denkbar, bei denen das Nutzsignal direkt herangezogen wird und einen Vorgang - hier eine Zustandsänderung des FlipFlops - auslöst, wenn der Wert U(t) des Nutzsignals einen bestimmten Wert über- oder unterschreitet.

Jede Bewegung, die schnell genug ist und den sensoraktiven Bereich überstreicht, löst diesen Vorgang aus, d.h., der Ausgang des ersten FlipFlops 32 wird zunächst auf aktiv gesetzt. Dazu reicht auch ein Überwischen oder ähnliche Bewegungen aus, die jedoch nicht als willentlicher Schaltvorgang erkannt werden sollen (s. Fign. 3.1 und 3.2). Deshalb wird das Nutzsignal einem zweiten Schwellwertschalter 34 zugeführt, welcher aktiv wird, wenn der Wert U(t) des Nutzsignals einen bestimmten zweiten Schwellwerts U_{G2} unterschreitet. Hier wird ausgenutzt, dass die Entfernung eines Objekts (Wegnahme eines Fingers) zu einem Absinken von U(t) in den negativen Bereich führt (Fig. 3.1). Bei Überschreitung des zweiten Schwellwertes U_{G2} des zweiten Schwellwertschalters 34, wird dessen Ausgangsspannung U₃₄ auf aktiv gesetzt (s. Figur 5).

Der Ausgang des Schwellwertschalters 34 ist mit dem Reset-Eingang des FlipFlops 32 verbunden, so dass bei einem Überwischen oder ähnlichem, welches das FlipFlop 32 auf aktiv gesetzt hat, dieses kurze Zeit später wieder zurückgesetzt wird. Das heißt, dass der Ausgang des FlipFlop 32 wieder auf Null zurückgesetzt wird. Das Ausgangssignal des FlipFlops 32 wird nun der Zeitdetektionsschaltung 33 zugeführt. Diese Schaltung ist so eingestellt, dass sein Ausgang nur dann auf aktiv gesetzt wird, wenn das FlipFlop 32 länger als eine vorbestimmte Zeit Δt₁, beispielsweise 100 ms, aktiv war. Diese vorbestimmte erste Zeitspanne Δt₁ entspricht etwa der übliche Mindestverweilzeit eines Fingers, einer Hand oder eines anderem Körperteil beim Antippen eines als elektrisches Schaltelement ausgebildeten Schalters.

Der Ausgang der Zeitdetektionsschaltung 33 ist mit dem Set-Eingang des zweiten FlipFlops 18 verbunden. Bei einem willentlichen Antippen der sensoraktiven Fläche wird somit der Ausgang des zweiten FlipFlops 18 auf aktiv gesetzt, da hier die Zeit zwischen Setzen des ersten FlipFlops 32 und Rücksetzen dieses FlipFlops größer ist als Δt₁, mit anderen Worten: Der Finger bleibt länger als Δt₁ auf der sensoraktiven Fläche 26. Bei Bewegungen jedoch, die keinen Schaltvorgang auslösen sollen - beispielsweise Überwischen mit einem Tuch -, ist die Zeit zwischen Setzen und Zurücksetzen des ersten FlipFlops 32 kleiner als Δt₁, so dass diese Bewegungen deshalb nicht zum Setzen des zweiten FlipFlops 18 führen. Durch Antippen der sensoraktiven Fläche wird also der Zustand des zweiten FlipFlops 18 kontrolliert verändert. Der Ausgang des FlipFlop 18 kann noch mit einem Schalter 23, beispielsweise ein Relais, verbunden sein.

In vielen Anwendungsfällen wird es erwünscht sein, dass das durch das Antippen der sensoraktiven Fläche 26 gesetzte zweite FlipFlop 18 durch gezielte Wegnahme des Fingers wieder zurückgesetzt wird. Dies ergibt dann die Funktion eines Tasters. Es ist jedoch vorteilhaft, wenn das Löschen des FlipFlops 18 erst dann erreicht wird, wenn der Finger einige Millimeter von der Glasplatte entfernt ist, um ein versehentliches Löschen des FlipFlops durch eine minimale Bewegung zu verhindern. Im hier dargestellten Ausführungsbeispiel wird dieses Problem wie folgt gelöst:

Der Momentanwert des am Ausgang des Operationsverstärkers 11 anliegenden Regelsignales U_{R}(t) wird zu einem Zeitpunkt abgetastet und gespeichert, an dem sich das annähernde Objekt noch kurz vor der Bedienoberfläche befindet. Um dies zu erreichen, wird dieses Signal der Verzögerungsschaltung 20 zugeführt. Der am Ausgang der Verzögerungsschaltung 20 anliegende Spannungswert U₂₀ wird im Speicher 21 zu dem Zeitpunkt t₀ gespeichert, zu dem am Ausgang des ersten Schwellwertschalters 17 ein Signal ansteht, also zu dem Zeitpunkt, zu dem der erste Schwellwertschalter 17 den Zeitpunkt des Antippens erkannt hat. Der so gespeicherte Wert U_{R}(t₀) wird einem ersten Eingang des Komparators 22 zugeführt. Am zweiten Eingang des Komparators liegt das Steuersignal mit dem Wert U_{R}(t) an. Solange der Wert des Steuersignals über dem Ausgangswert des Speichers 21 liegt, liefert die Komparatorschaltung 22 kein Ausgangssignal. Wenn jedoch der Wert des Steuersignals zum Zeitpunkt t₁ unter den gespeicherten Wert sinkt, wird der Ausgang des Komparators auf aktiv gesetzt. Die Signale U₂₀, U_{R}(t) und U_{R}(t₀) sind in Fig. 6 dargestellt. Mit diesem Signal wird das zweite FlipFlop 18 zurückgesetzt.

Das Prinzip der Erfindung beruht grundsätzlich darauf, ein von einem Näherungssensor, insbesondere von einem opto-elektronischen Näherungssensor stammendes Nutzsignal auszuwerten, dessen Wert U(t) sich bei Annäherung eines Objekts an und bei Wegnahme eines Objekts von dem Näherungssensor ändert und Richtung und Betrag dieser Änderung charakteristisch für Richtung und Geschwindigkeit und/oder Abstand des Objekts sind.

Ein erstes Erkennungsmittel 17 ändert dazu seinen Schaltzustand von einem ersten zu einem zweiten Zustand, wenn der Wert U(t) des Nutzsignals oder ein Wert U₁(t) eines aus diesem Nutzsignal erzeugten ersten Signals einen für die Annäherung eines Objekts charakteristischen ersten Grenzwert überschreitet oder unterschreitet. Ein zweites Erkennungsmittel 34 ändert seinen Schaltzustand von einem ersten zu einem zweiten Zustand, wenn der Wert U(t) des Nutzsignals oder der Wert eines aus diesem Nutzsignal erzeugten zweiten Signals einen für die Wegnahme eines Objekts charakteristischen zweiten Grenzwert überschreitet oder unterschreitet. Mit den Erkennungsmitteln 17, 34 verbunden ist ein Entscheidungsmittel 32, das seinen Ausgangszustand von einem ersten in einen zweiten Zustand ändert, wenn das erste Erkennungsmittel 17 seinen Schaltzustand von seinem ersten zu seinem zweiten Zustand ändert und das zweite Erkennungsmittel seinen Schaltzustand innerhalb einer vorbestimmten ersten Zeitspanne Δt₁ nach Änderung des Schaltzustandes des ersten Erkennungsmittels nicht ändert.

In einer Weiterbildung kann das Prinzip weitere Elemente umfassen. So setzt z.B. ein drittes Erkennungsmittel den Ausgangszustand des Entscheidungsmittels vom zweiten zum ersten Ausgangszustand zurück, wenn der Wert U(t) des Nutzsignals oder der Wert U₃(t) eines aus diesem Nutzsignal erzeugten dritten Signals einen für die Wegnahme des Objektes charakteristischen dritten Grenzwert unterschreitet oder überschreitet. Der dritte Grenzwert wird vorzugsweise aus dem zeitlichen Verlauf des Nutzsignals oder eines aus dem Nutzsignal erzeugten Signals generiert. Dieser dritte Grenzwert entspricht dem Wert U(t) des

Nutzsignals oder eines aus dem Nutzsignal erzeugten Signals zu einem Zeitpunkt, der eine gewisse vorbestimmte Zeitspanne vor dem Zeitpunkt (t₀) des Ändems des Zustandes des ersten Erkennungsmittels (17) liegt. Dies lässt sich durch einen festen Teilfaktor oder durch ein zeitliches Verzögern des Steuersignals U_{R}(t) erreichen, um dadurch von Verschleißerscheinungen z.B. der Oberfläche des Schalters unabhängig zu sein. Nutzsignal, erstes Signal und zweites Signal sind vorzugsweise analoge Spannungssignale.

Im Entscheidungsmittel setzt das erste Erkennungsmittel 17 ein erstes FlipFlop 32 und das zweite Erkennungsmittel 34 das erste FlipFlop 32 zurück. Eine mit dem Ausgang des ersten FlipFlops 17 verbundene Zeitdetektionsschaltung 33 wird auf aktiv gesetzt, wenn der Ausgang des ersten FlipFlops 32 für eine Zeitspanne auf aktiv gesetzt war, die länger als die vorbestimmte Zeitspanne Δt1 ist. Der Ausgang der Zeitdetektionsschaltung 33 setzt ein zweites FlipFlop 18.

Gebildet werden kann damit ein opto-elektronischer Schalter, der mit wenigstens einem Licht emittierenden Sendeelement und wenigstens einem Empfangselement ausgerüstet ist.. Das Empfangselement gibt seine Signale, deren Wert von der empfangenen Lichtmenge abhängt, an eine Auswerteeinheit weiter, in der zumindest ein Schaltelement seinen Schaltzustand ändert, wenn der Wert des ersten Signals oder der Wert eines aus diesem Signal abgeleitetes weiteres Signal vorgegebene Grenzwerte über- oder unterschreitet. Sende- und Empfangselement können so angeordnet sein, dass das vom Sendeelement kommende Licht von Objekten, die sich innerhalb eines bestimmten Bereichs befinden, oder von einem in einem vorgegebenen räumlichen Verhältnis zu Empfangselement und Sendeelement stehenden beweglichen Element derart gestreut oder reflektiert wird, dass zumindest ein Teil dieses gestreuten oder reflektierten Lichtes in das Empfangselement gelangt. Damit verursacht die durch eine Bewegung des Objekts oder des beweglichen Elements verursachte Änderung der vom Empfangselement empfangenen Menge an reflektiertem oder gestreutem Licht eine Zustandsänderung des Schaltelements verursacht, wenn die Bewegung innerhalb von Grenzen eines vorgegebenen Bewegungsmusters liegt.

Dieses Bewegungsmuster ist vorzugsweise ein Antippen eines definierten Bereiches mit Finger, Hand oder einem anderen Körperteil. Angetippt weiden kann z.B. ein definierter Bereich einer Glas- oder Plexiglasscheibe oder eines mit Sende- und/oder Empfangselement verbundenen Lichtleiters.

Das angesprochene bewegliche Element kann z.B. eine Schnappfeder sein, wie sie in üblichen Schaltern zum Teil verwendet wird. Erkannt wird von den Erkennungsmitteln dann das Bewegungsmuster dieser Schnappfeder allein oder in Ergänzung zu der Annäherung des Objekts. Z.B. kann die Schnappfeder auf dem Näherungssensor liegen, um dem Benutzer den Schalteffekt taktil zu verdeutlichen, allerdings kann auch die Bewegung des beweglichen Elements allein erfasst und ausgewertet werden. Die Schnappfeder ist gegen eine Rückstellkraft bewegbar und kann z.B. beim Bewegen gegen die Rückstellkraft einen Totpunkt überwinden.

## Patentansprüche

1. Vorrichtung zum Auswerten eines von einem Näherungssensor, insbesondere von einem opto-elektronischen Näherungssensor stammenden Nutzsignals, wobei sich der Wert (U(t)) des Nutzsignals bei der Annäherung eines Objekts an und bei der Wegnahme eines Objekts von dem Näherungssensor ändert und Richtung und Betrag dieser Änderung charakteristisch für Richtung und Geschwindigkeit und/oder Abstand des Objekts sind, mit
- einem ersten Erkennungsmittel (17), das seinen Schaltzustand von einem ersten zu einem zweiten Zustand ändert, wenn ein erster Wert (U(t)) des Nutzsignals oder ein erster Wert (U₁(t)) eines aus diesem Nutzsignal erzeugten ersten Signals einen für die Annäherung eines Objekts charakteristischen ersten Grenzwert überschreitet oder unterschreitet,
- einem zweiten Erkennungsmittel (34), das seinen Schaltzustand ändert, wenn ein zweiter Wert (U(t), (U₁(t)) einen für die Annäherung eines Objekts charakteristischen zweiten Grenzwert überschreitet oder unterschreitet,
- einem mit dem ersten und dem zweiten Erkennungsmittel (17,34) verbundenen Entscheidungsmittel (32), das seinen Ausgangszustand von einem ersten in einen zweiten Zustand ändert, wenn das erste Erkennungsmittel (17) seinen Schaltzustand von seinem ersten zu einem zweiten Zustand ändert und wenn das zweite Erkennungsmittel (34) seinen Schaltzustand nicht ändert,
**dadurch gekennzeichnet, dass**
- das zweite Erkennungsmittel (34) seinen Schaltzustand bei der Wegnahme des Objekts ändert,
- das Entscheidungsmittel (32) seinen zweiten Zustand beibehält, wenn zusätzlich das zweite Erkennungsmittel (34) seinen Schaltzustand innerhalb einer vorbestimmten ersten Zeitspanne nach Änderung des Schaltzustandes des ersten Erkennungsmittels nicht ändert, und
- der Ausgang einer mit dem Ausgang des Entscheidungsmittels (32) verbundenen Zeitdetektionsschaltung (33) aktiv gesetzt wird, wenn der Ausgang des Entscheidungsmittels (32) für eine Zeitspanne auf aktiv gesetzt war, die länger als die vorbestimmte Zeitspanne ist und
- ein FlipFlop (18) mit seinem Set-Eingang mit dem Ausgang der Zeitdetektionsschaltung (33) verbunden ist.

2. Vorrichtung nach Anspruch 1, **dadurch gekennzeichnet, dass** ein drittes Erkennungsmittel (20,21,22) vorgesehen ist, das den Ausgangszustand des FlipFlops (18) vom zweiten zum ersten Ausgangszustand zurücksetzt, wenn der Wert (U(t)) des Nutzsignals oder der Wert (U_{R}(t)) eines aus diesem Nutzsignal erzeugten dritten Signals einen für die Wegnahme des Objektes charakteristischen dritten Grenzwert unterschreitet oder überschreitet.

3. Vorrichtung nach Anspruch 2, **dadurch gekennzeichnet, dass** der dritte Grenzwert aus dem zeitlichen Verlauf des Nutzsignals oder eines aus dem Nutzsignal erzeugten Signals generiert wird.

4. Vorrichtung nach Anspruch 3, **dadurch gekennzeichnet, dass** der dritte Grenzwert dem Wert U(t) des Nutzsignals oder eines aus dem Nutzsignal erzeugten Signals zu einem Zeitpunkt entspricht, der eine gewisse vorbestimmte Zeitspanne vor dem Zeitpunkt (t₀) des Änderns des Zustandes des ersten Erkennungsmittels (17) liegt.

5. Vorrichtung nach einem der vorangehenden Ansprüche, **dadurch gekennzeichnet, dass** den Erkennungsmitteln (17,34) das Entscheidungsmittel (32) und diesem mittelbar ein elektrisches Schaltelement (23) derart nachgeordnet ist, dass die Änderung des Schaltzustandes des Entscheidungsmittels (32) zum Schalten des Schaltelements (23) führt.

6. Vorrichtung nach einem der vorangehenden Ansprüche, **dadurch gekennzeichnet, dass** das Nutzsignal, das erste Signal und das zweite Signal analoge Spannungssignale sind.

7. Vorrichtung nach Anspruch 6, **dadurch gekennzeichnet, dass** das erste Erkennungsmittel aus einem Hochpass (16), an dessen Eingang das Nutzsignal (U(t)) anliegt, und einem nachgeordneten ersten Schwellwertschalter (17) besteht.

8. Vorrichtung nach Anspruch 6 oder 7, **dadurch gekennzeichnet, dass** das zweite Erkennungsmittel ein zweiter Schwellwertschalter (34) ist, an dessen Eingang das Nutzsignal (U(t)) anliegt.

9. Vorrichtung nach den Ansprüchen 6 bis 8, **dadurch gekennzeichnet, dass** das Entscheidungsmittel folgende Bestandteile aufweist:
- ein weiteres FlipFlop (32), dessen Set-Eingang mit dem Ausgang des ersten Schwellwertschalters (17) und dessen Reset-Eingang mit dem Ausgang des zweiten Schwellwertschalters (34) verbunden ist,
- einer mit dem Ausgang des weiteren FlipFlops (32) verbundenen Zeitdetektionsschaltung (33), deren Ausgang aktiv gesetzt wird, wenn der Ausgang des weiteren FlipFlops (32) für eine Zeitspanne auf aktiv gesetzt war, die länger als die vorbestimmte Zeitspanne ist.

10. Vorrichtung nach einem der Ansprüche 1 bis 9, **dadurch gekennzeichnet, dass** das sich nähernde Objekt wenigstens ein Finger, eine Hand oder ein anderes Körperteil eines Benutzers ist und dass die vorbestimmte erste Zeitspanne der üblichen Verweilzeit des Fingers, der Hand oder des anderen Körperteil beim Antippen eines als elektrisches Schaltelement ausgebildeten Schalters entspricht.

11. Verfahren zum Auswerten eines von einem Näherungssensor, insbesondere von einem opto-elektronischen Näherungssensor stammenden Nutzsignals mit einer Vorrichtung nach einem der vorhergehenden Ansprüche, wobei sich ein Wert (U(t)) des Nutzsignals oder ein Wert (U₁(t)) eines aus diesem Nutzsignal erzeugten bei der Annäherung eines Objekts an und bei der Wegnahme eines Objekts von dem Näherungssensor ändert und Richtung und Betrag dieser Änderung charakteristisch für Richtung und Geschwindigkeit und/oder Abstand des Objekts sind, mit den Schritten:
- Erkennen der Annäherung des Objekts und Schalten eines ersten Erkennungsmittels (17), wenn der erste Wert (U(t),(U₁(t)) eines ersten Signals einen für die Annäherung des Objekts charakteristischen ersten Grenzwert überschreitet oder unterschreitet,
- Erkennen der Annäherung des Objekts und Schalten eines zweiten Erkennungsmittels (34), wenn der zweite Wert (U(t),(U₁(t)) einen für die Annäherung des Objekts charakteristischen zweiten Grenzwert überschreitet oder unterschreitet,
- Ändern des Ausgangszustands eines mit den Erkennungsmitteln (17,34) verbundenen Entscheidungsmittels (32), wenn das erste Erkennungsmittel (17) seinen Zustand ändert und wenn das zweite Erkennungsmittel (34) seinen Schaltzustand nicht ändert,
**gekennzeichnet durch** die weiteren Schritte
- Erkennen der Wegnahme des Objekts unter Schalten des zweiten Erkennungsmittel (34),
- Beibehalten des zweiten Zustands des Entscheidungsmittels (32), wenn zusätzlich das zweite Erkennungsmittel seinen Schaltzustand innerhalb einer vorbestimmten ersten Zeitspanne nach Änderung des Schaltzustandes des ersten Erkennungsmittels nicht ändert.
- aktiv Setzen des Ausgangs einer mit dem Ausgang des Entscheidungsmittels (32) verbundenen Zeitdetektionsschaltung (33), wenn der Ausgang des Entscheidungsmittels (32) für eine Zeitspanne auf aktiv gesetzt war, die länger als die vorbestimmte Zeitspanne ist und
- Verbinden eines FlipFlops (18) mit seinem Set-Eingang mit dem Ausgang der Zeitdetektionsschaltung (33).

12. Verfahren nach Anspruch 11, **dadurch gekennzeichnet, dass** ein drittes Erkennungsmittel (20,21,22) den Ausgangszustand des FlipFlops (18) vom zweiten Zustand zum ersten Ausgangszustand zurücksetzt, wenn der Wert (U(t)) des Nutzsignals oder der Wert (U_{R}(t)) eines aus diesem Nutzsignal erzeugten dritten Signals einen für die Wegnahme des Objektes charakteristischen dritten Grenzwert unterschreitet oder überschreitet.

13. Verfahren nach Anspruch 12, **dadurch gekennzeichnet, dass** der dritte Grenzwert aus dem zeitlichen Verlauf des Nutzsignals oder eines aus dem Nutzsignal erzeugten Signals generiert wird, das vorzugsweise eine gewisse vorbestimmte Zeitspanne vor dem Zeitpunkt (t₀) des Ändems des Zustandes des ersten Erkennungsmittels (17) liegt.

14. Verfahren nach einem der Ansprüche 11 bis 13, **dadurch gekennzeichnet, dass** die Änderung des Zustands des FlipFlops (18) ein elektrisches Schaltelement (23) schaltet.

15. Verfahren nach einem der Ansprüche 11 bis 14, **dadurch gekennzeichnet, dass** im Entscheidungsmittel das erste Erkennungsmittel (17) ein weiteres FlipFlop (32) setzt und das zweite Erkennungsmittel (34) das weitere Flip-Flop (32) zurücksetzt, und dass eine mit dem Ausgang des weiteren FlipFlops (32) verbundene Zeitdetektionsschaltung (33) auf aktiv gesetzt wird, wenn der Ausgang des weiteren FlipFlops (32) für eine Zeitspanne auf aktiv gesetzt war, die länger als die vorbestimmte Zeitspanne ist.

## Claims

1. Device for evaluating a useful signal originating from a proximity sensor, more especially from an opto-electronic proximity sensor, wherein the value (U(t)) of the useful signal changes with the approximation of an object to the proximity sensor and with the removal of an object from the proximity sensor and the direction and amount of this change are characteristic of the direction and speed and/or distance of the object, the device comprising
- a first recognizing means (17), which changes its switching state from a first to a second state when a first value (U(t)) of the useful signal, or a first value (U₁(t)) of a signal generated from this useful signal, exceeds or falls below a first limit value, which is characteristic of the approximation of an object,
- a second recognizing means (34), which changes its switching state from a first to a second state when a second value (U(t), U₁(t)) exceeds or falls below a second limit value, which is characteristic of the removal of an object and
- a deciding means (32) which is connected to the first recognizing means (17) and the second recognizing means (34) and changes its output state from a first into a second switching state when the first recognizing means (17) changes its switching state from its first to its second state and the second recognizing means does not change its switching state,
**characterized in that**
- the second recognizing means (32) changes its switching state when the object is removed,
- the deciding means (32) maintains its second state when in addition the second recognizing means (34) does not change its switching state within a predetermined first time slot once the switching state of the first recognizing means has been changed, and
- the output of a time detection circuit (33), which is connected to the output of the deciding means (32), is set to active when the output of the deciding means (32) has been set to active for a time slot which is longer than the predetermined time slot and
- a flip-flop (18) is connected with its set terminal to the output of the time detection circuit (33).

2. Device according to claim 1, **characterized in that** a third recognizing means (20, 21, 22) is provided, which resets the output state of the flip-flop (18) from the second back to the first output state when the value (U(t)) of the useful signal or the value (U_{R}(t)) of a third signal generated from this useful signal, falls below or exceeds a third limit value, which is characteristic of the removal of the object.

3. Device according to claim 2, **characterized in that** the third limit value is generated from the time curve of the useful signal or of a signal generated from the useful signal.

4. Device according to claim 3, **characterized in that** the third limit value corresponds to the value (U(t)) of the useful signal or of a signal generated from the useful signal at a moment which lies a certain predetermined time slot before the moment (t₀) of the changing of the state of the first recognizing means (17).

5. Device according to one of the preceding claims, **characterized in that** the deciding means (32) is connected downstream of the recognizing means (17, 34) and an electric switching element (23) is connected indirectly downstream of this latter such that the change in the switching state of the deciding means (32) results in the switching of the switching element (23).

6. Device according to one of the preceding claims, **characterized in that** the useful signal, the first signal and the second signal are analogue voltage signals.

7. Device according to claim 6, **characterized in that** the first recognizing means consists of a high-pass filter (16), at the input of which is the useful signal (U(t)), and a first threshold value switch (17), which is connected downstream.

8. Device according to claim 6 or 7, **characterized in that** the second recognizing means is a second threshold value switch (34), at the input of which is the useful signal (U(t)).

9. Device according to claims 6 to 8, **characterized in that** the deciding means has the following component parts:
- an additional flip-flop (32), the set input of which is connected to the output of the first threshold value switch (17) and the reset input of which is connected to the output of the second threshold value switch (34),
- a time detection circuit (33) connected to the output of the additional flip-flop (32), the output of which time detection circuit is set to active when the output of the additional flip-flop (32) has been set to active for a time slot which is longer than the predetermined time slot.

10. Device according to one of claims 1 to 9, **characterized in that** the approaching object is at least one finger, one hand or another body part of a user, and **in that** the predetermined first time slot corresponds to the normal dwell time of the finger, the hand or the other body part when tapping a switch which is configured as an electric switching element.

11. Method for evaluating a useful signal originating from a proximity sensor, more especially from an opto-electronic proximity sensor, using a device in accordance with one of the preceding claims, wherein the value (U(t)) of the useful signal changes when an object approaches the proximity sensor and when an object is removed from the proximity sensor and the direction and amount of this change are characteristic of the direction and speed and/or distance of the object, the method comprising the steps:
- recognising the approaching of the object and switching of a first recognizing means (17) when the value (U(t), U₁(t)) of a first signal exceeds or falls below a first limit value which is characteristic of the approaching of an object,
- recognising the approaching of the object and switching of a second recognizing means (34) when the second value (U(t)), (U₁(t)) exceeds or falls below a second limit value characteristic of the approaching of the object and
- changing the output state of a deciding means (32) which is connected to the recognizing means (17, 34) when the first recognizing means (17) changes its state and when the second recognizing means (34) does not change its state,
**characterized by** the further steps
- recognising the removal of the object by switching a second recognizing means (34),
- maintaining the second state of the deciding means (32) when in addition the second recognizing means does not change its switching state within a predetermined first time slot once the switching state of the first recognizing means has been changed,
- setting to active the output of a time detection circuit (33), which is connected to the output of the deciding means (32), when the output of the deciding means (32) has been set to active for a time slot which is longer than the predetermined time slot, and
- connecting a flip-flop (18) with its set terminal to the output of the time detection circuit (33).

12. Method according to claim 11, **characterized in that** a third recognizing means (20, 21, 22) resets the output state of the flip-flop (18) from the second state back to the first output state when the value (U(t)) of the useful signal or the value (UR(t)) of a third signal generated from this useful signal falls below or exceeds a third limit value which is characteristic of the removal of the object.

13. Method according to claim 12, **characterized in that** the third limit value is generated from the time curve of the useful signal or of a signal generated from the useful signal, which lies preferably a certain predetermined time slot before the moment (t₀) of the changing of the state of the first recognizing means (17).

14. Method according to one of the claims 11 to 13, **characterized in that** the change in state of flip-flop(18) switches an electric switching element (23).

15. Method according to one of the claims 11 to 14, **characterized in that** in the deciding means the first recognizing means (17) sets an additional flip-flop (32) and the second recognizing means (34) resets the additional flip-flop (32), and **in that** a time detection circuit (33), which is connected to the output of the additional flip-flop (32), is set to active when the output of the additional flip-flop (32) has been set to active for a time slot which is longer than the predetermined time slot.

## Revendications

1. Dispositif d'exploitation d'un signal utile provenant d'un capteur de proximité, en particulier d'un capteur de proximité opto-électronique, la valeur (U(t)) du signal utile variant lorsqu'un objet s'approche et s'éloigne du capteur de proximité, et la direction ainsi que la valeur absolue de cette variation étant caractéristique de la direction et de la vitesse et/ou de la distance de l'objet, comportant
- un premier moyen de reconnaissance (17) qui modifie son état de commutation d'un premier à un deuxième état lorsqu'une première valeur (U(t)) du signal utile ou une première valeur (U₁(t)) d'un premier signal produit à partir de ce signal utile dépasse ou sous-dépasse une première valeur limite caractéristique de l'approche d'un objet,
- un deuxième moyen de reconnaissance (34) qui modifie son état de commutation lorsqu'une deuxième valeur (U(t)), (U₁(t)) dépasse ou sous-dépasse une deuxième valeur limite caractéristique de l'approche d'un objet,
- un moyen de décision (32) relié au premier et au deuxième moyen de reconnaissance (17, 34) qui modifie son état initial d'un premier à un deuxième état lorsque le premier moyen de reconnaissance (17) modifie son état de commutation de son premier à son deuxième état, et lorsque le deuxième moyen de reconnaissance (34) ne modifie pas son état de commutation,
**caractérisé en ce que**
- le deuxième moyen de reconnaissance (34) modifie son état de commutation lorsque l'objet s'éloigne,
- le moyen de décision (32) conserve son deuxième état lorsqu'en supplément le deuxième moyen de reconnaissance (34) ne modifie pas son état de commutation à l'intérieur d'un premier intervalle de temps prédéterminé, après modification de l'état de commutation du deuxième moyen de reconnaissance, et
- la sortie d'un circuit de détection de temps (33), reliée à la sortie du moyen de décision (32), est activée lorsque la sortie du moyen de décision (32) était activée pendant un intervalle de temps qui était plus long que l'intervalle de temps prédéterminé et
- une bascule (18) est reliée par son entrée de réglage à la sortie du circuit de détection de temps (33).

2. Dispositif selon la revendication 1, **caractérisé en ce qu'**il est prévu un troisième moyen de reconnaissance (20, 21, 22) qui replace l'état initial de la bascule (18) du premier au deuxième état initial lorsque la valeur (U(t)) du signal utile ou la valeur (U_{R}(t)) d'un troisième signal, produit à partir de ce signal utile, dépasse ou sous-dépasse une troisième valeur limite caractéristique de l'éloignement de l'objet.

3. Dispositif selon la revendication 2, **caractérisé en ce que** la troisième valeur limite est générée à partir de l'allure dans le temps du signal utile ou d'un signal produit à partir du signal utile.

4. Dispositif selon la revendication 3, **caractérisé en ce que** la troisième valeur limite correspond à la valeur (U(t)) du signal utile ou d'un signal produit à partir du signal utile à un instant qui se situe à un certain intervalle de temps prédéterminé avant l'instant (t₀) de la modification de l'état du premier moyen de reconnaissance (17).

5. Dispositif selon l'une des revendications précédentes, **caractérisé en ce qu'**en aval des moyens de reconnaissance (17, 34) est disposé le moyen de décision (32) et en aval de celui-ci, indirectement, un élément électrique de commutation (23) de manière que la modification de l'état de commutation du moyen de décision (32) entraîne la commutation de l'élément de commutation (23).

6. Dispositif selon l'une des revendications précédentes, **caractérisé en ce que** le signal utile, le premier signal et le deuxième signal sont des signaux analogiques de tension.

7. Dispositif selon la revendication 6, **caractérisé en ce que** le premier moyen de reconnaissance est constitué d'un passe-haut (16) à l'entrée duquel s'applique le signal utile (U(t)), et d'un premier interrupteur à valeur de seuil (17) disposé en aval.

8. Dispositif selon la revendication 6 ou 7, **caractérisé en ce que** le deuxième moyen de reconnaissance est un deuxième interrupteur à valeur de seuil (34) à l'entrée duquel s'applique le signal utile (U(t)).

9. Dispositif selon les revendications 6 à 8, **caractérisé en ce que** le moyen de reconnaissance comporte les éléments constitutifs suivants :
- une autre bascule (32) dont l'entrée de réglage est reliée à la sortie du premier interrupteur à valeur de seuil (17) et dont l'entrée de remise à zéro est reliée à la sortie du deuxième interrupteur à valeur de seuil (34),
- un circuit de détection de temps (33) relié à la sortie de l'autre bascule (32), dont la sortie est activée lorsque la sortie de l'autre bascule (32) était activée pendant un intervalle de temps qui était plus long que l'intervalle de temps prédéterminé.

10. Dispositif selon l'une des revendications 1 à 9, **caractérisé en ce que** l'objet s'approchant est au moins un doigt, une main ou une autre partie du corps d'un utilisateur, et **en ce que** le premier intervalle de temps prédéterminé correspond au temps d'arrêt usuel du doigt, de la main ou de l'autre partie du corps lorsque l'on touche un interrupteur réalisé comme élément électrique de commutation.

11. Procédé d'exploitation d'un signal utile provenant d'un capteur de proximité, en particulier d'un capteur de proximité opto-électronique, comportant un dispositif selon l'une des revendications précédentes, une valeur (U(t)) du signal utile ou une valeur (U₁(t)) d'un signal produit à partir de ce signal utile variant lorsqu'un objet s'approche ou s'éloigne du capteur de proximité et la direction et la valeur absolue de cette variation étant caractéristiques de la direction et de la vitesse et/ou de l'éloignement de l'objet, comportant les étapes :
- reconnaissance de l'approche de l'objet et commutation d'un premier moyen de reconnaissance (17) lorsque la première valeur (U(t)), (U₁(t)) d'un premier signal dépasse ou sous-dépasse une première valeur limite caractéristique de l'approche de l'objet,
- reconnaissance de l'approche de l'objet et commutation d'un deuxième moyen de reconnaissance (34) lorsque la deuxième valeur (U(t)), (U₁(t)) dépasse ou sous-dépasse une deuxième valeur limite caractéristique de l'approche de l'objet,
- modification de l'état initial d'un moyen de décision (32), relié aux moyens de reconnaissance (17, 34), lorsque le premier moyen de reconnaissance (17) modifie son état et lorsque le deuxième moyen de reconnaissance (34) ne modifie pas son état de commutation,
**caractérisé par** les étapes complémentaires suivantes :
- reconnaissance de l'éloignement de l'objet avec commutation du deuxième moyen de reconnaissance (34),
- maintien du deuxième état du moyen de décision (32) lorsqu'en supplément le deuxième moyen de reconnaissance ne modifie pas son état de commutation à l'intérieur d'un premier intervalle de temps prédéterminé, après variation de l'état de commutation du premier moyen de reconnaissance,
- activation de la sortie d'un circuit de détection de temps (33), reliée à la sortie du moyen de décision (32), lorsque la sortie du moyen de décision (32) était activée pendant un intervalle de temps qui était supérieur à l'intervalle de temps prédéterminé, et
- connexion d'une bascule (18) par son entrée de réglage à la sortie du circuit de détection de temps (33).

12. Procédé selon la revendication 11, **caractérisé en ce qu'**un troisième moyen de reconnaissance (20, 21, 22) replace l'état initial de la bascule (18) du deuxième état au premier état initial, lorsque la valeur (U(t)) du signal utile ou la valeur (U_{R}(t)) d'un troisième signal, produit à partir de ce signal utile, dépasse ou sous-dépasse une troisième valeur limite caractéristique de l'éloignement de l'objet.

13. Procédé selon la revendication 12, **caractérisé en ce que** la troisième valeur limite est générée à partir de l'allure dans le temps du signal utile ou d'un signal produit à partir du signal utile, qui se situe de préférence à un certain intervalle de temps prédéterminé avant l'instant (t₀) de la modification de l'état du premier moyen de reconnaissance (17).

14. Procédé selon l'une des revendications 11 à 13, **caractérisé en ce que** la modification de l'état de la bascule (18) fait commuter un élément électrique de commutation (23).

15. Procédé selon l'une des revendications 11 à 14, **caractérisé en ce que** dans le moyen de décision, le premier moyen de reconnaissance (17) règle une autre bascule (32) et le deuxième moyen de reconnaissance (34) réinitialise l'autre bascule (32), et **en ce qu'**un circuit de détection de temps (33), relié à la sortie de l'autre bascule (32), est activé lorsque la sortie de l'autre bascule (32) était active pendant un intervalle de temps qui était plus long que l'intervalle de temps prédéterminé.
